# EUROPEAN PATENT SPECIFICATION

(11) **EP 0 373 885 B1**
(45) Date of publication and mention of the grant of the patent: **28.02.1996**
(21) Application number: 89312971.8
(22) Date of filing: 12.12.1989
(51) Int. Cl.: G11C 11/409, G11C 11/407, G11C 5/06, G11C 5/14

(54) **Semiconductor integrated device having pairs of undecided voltage portions**
Integrierte Halbleiteranordnung mit Paaren von Teilen unbestimmter Spannung
Dispositif intégré à semi-conducteurs ayant des paires de parties de tension indéterminée

(30) Priority: 13.12.1988 JP 312799/88
(43) Date of publication of application: 20.06.1990
(73) Proprietor: FUJITSU LIMITED, Kawasaki-shi, Kanagawa 211 (JP)
(72) Inventor: Nishiguchi, Tadao, Kawasaki-shi Kanagawa 211 (JP); Tatematsu, Takeo, Midori-ku Yokohama-shi Kanagawa 227 (JP); Kasuta, Yoshinori, Nakahara-ku Kawasaki-shi Kanagawa 211 (JP)
(74) Representative: Bedggood, Guy Stuart

(56) References cited:
- EP-A- 0 197 639
- DE-A- 2 553 591
- GB-A- 2 112 568
- US-A- 4 291 394
- IEEE JOURNAL OF SOLID STATE CIRCUITS, vol. 19, no. 5, 1984, pages 591-596, IEEE, New York, US; K. MASHIKO et al.: "A 70 ns 256K DRAM with bit-line shield"

## Description

The present invention relates to a semiconductor integrated device such as a dynamic metal-insulator-semiconductor (MIS) random access memory (RAM) having a plurality of pairs of undecided voltage portions which are in an undecided (floating) state for a certain time, and a plurality of sense amplifiers for amplifying a small difference in potential between each pair of undecided voltage portions.

Recently, the integration and fining of the structure of a semiconductor integrated device such as a MIS memory device has become greater, and this has given rise to serious problems with regard to the conductor-spacing capacities between internal connections.

For example, in a MIS memory device, a pair of undecided voltage portions, such as a pair of folded bit lines which are in an undecided state, i.e., in a floating state, for a certain time are provided, and a small difference in potential therebetween corresponding to a content of a memory cell is amplified by a sense amplifier for such a time to generate the content therefrom. In this case, an operation clock signal line crosses over or down the bit lines. Therefore, conductor-spacing capacities exist between one of the bit lines and the operation clock signal line and between the other bit line and the operation clock signal line, and in this case, the two conductor-spacing capacities are the same.

On the other hand, a decided voltage portion, such as a power supply line for the sense amplifier, may be arranged near the bit lines. Here too conductor-spacing capacities exist between one of the bit lines and the power supply line and between the other of the bit lines and the power supply line. In this case, however, the two capacities are different from each other.

Thus, in an undecided (floating) state of the bit lines, even when the potential at the operation clock signal line is changed, a small difference in potential occurs between the bit lines, owing to the difference in capacitances of the bit lines with respect to the power supply line. Therefore, when a difference in potential corresponding to the content of a memory cell is added to the above-mentioned difference in potential between the bit lines, the sense amplifier may be erroneously operated. This will be discussed later in detail.

Coupling noise due to unequal parasitic capacitances associated with the outer data lines in a memory cell array are discussed in GB 2112568 (Hitachi), comprising the features of the preamble of claim 1. Here the problem is solved by the use of dummy data lines coupled to dummy sense amplifiers. This entails a considerable cost in terms of complexity and chip area.

It is desirable to provide a semiconductor integrated device in which an erroneous operation by noise due to the conductor-spacing capacities does not occur.

According to the present invention there is therefore provided a semiconductor integrated device comprising: a plurality of pairs of undecided voltage portions which during operation are in an undecided, floating state for a certain time; a plurality of sensing means each connected to one of the pairs of undecided voltage portions, for sensing a small difference in potential between the portions; a decided voltage portion arranged on an outer side of the undecided voltage portion pairs; a signal line crossing the pairs of undecided voltage portions; a capacitance-increasing means arranged in the vicinity of the outermost undecided voltage portions, this capacitance-increasing means comprising a conductor branching from the signal line and extending in parallel to the said outermost undecided voltage portions. As a result, the conductor-spacing capacity between the undecided voltage portion of the outer side pair nearer to the decided voltage portion and the peripheral conductors thereof is substantially the same as the conductor-spacing capacity between the other undecided voltage portion of the pair and the peripheral conductors thereof. Therefore, even when the undecided voltage portions are in an undecided (floating) state and the potential at the signal line is changed, there is no substantial difference in potential between the undecided voltage portions of the outer side pair, and therefore, sense amplifiers for sensing the potentials at the undecided voltage portions are not erroneously operated.

The invention is particularly suitable for dynamic random-access memory devices.

Reference is made, by way of example, to the accompanying drawings, in which:
Fig. 1 is a circuit diagram illustrating a proposed semiconductor integrated device,
Figs. 2A and 2B are timing diagrams showing the operation of the circuit of Fig. 1;
Fig. 3 is a circuit diagram illustrating a semiconductor integrated device to which the invention can be applied;
Fig. 4 is a circuit diagram illustrating an embodiment of the semiconductor integrated device according to the present invention;
Fig. 5 is a partial plan view of Fig. 4;
Figs. 6A through 6H are timing diagrams showing the operation of the circuit of Fig. 4; and
Fig. 7 is a circuit diagram showing an embodiment of the semiconductor integrated device according to the present invention.
Figs. 8A through 8F are timing diagrams showing the operation of the circuit of Fig. 7;

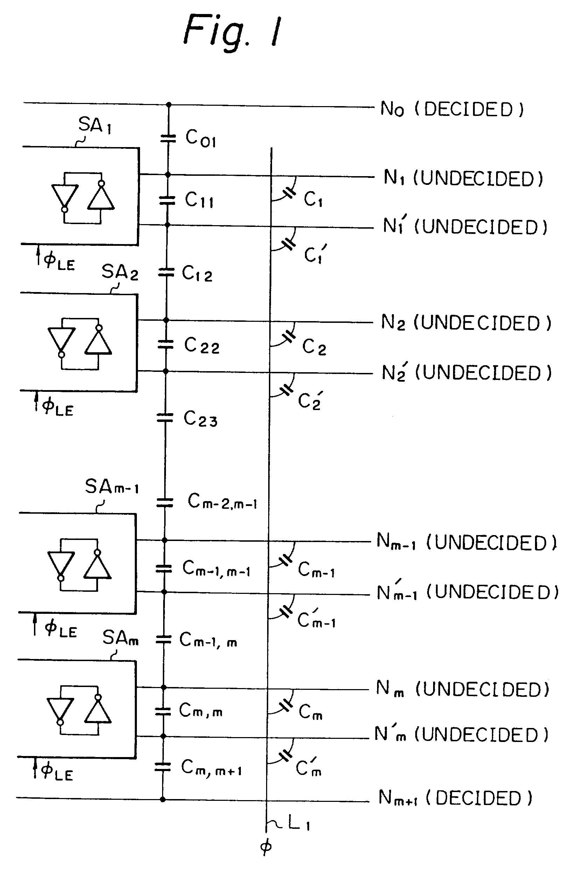

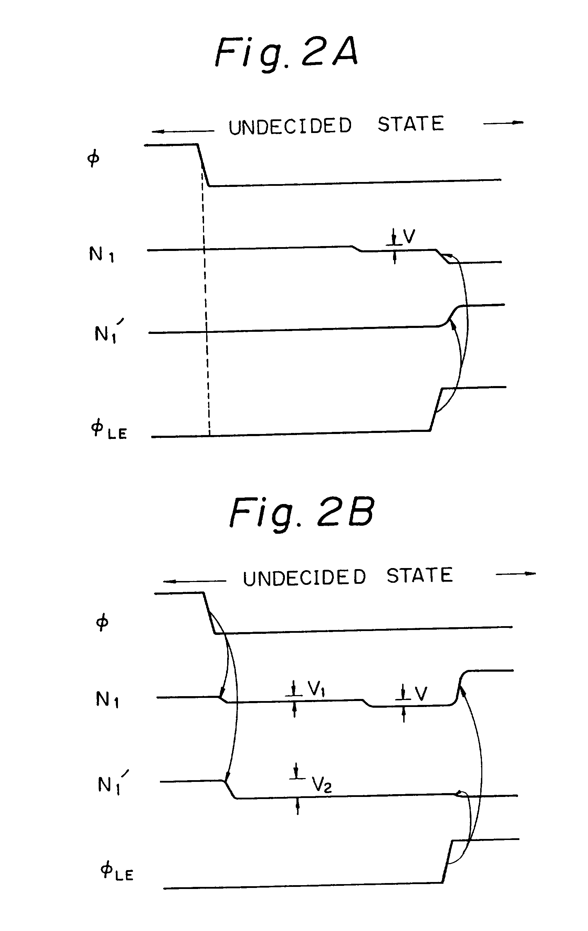

Before the description of the embodiments, a prior art semiconductor integrated device will be described with reference to Figs. 1, 2A, and 2B.

In Fig. 1, a plurality of pairs of undecided Nₘ' voltage portions N₁ , N₁'; N₂, N₂'; ... ; Nₘ₋₁ , Nₘ₋₁', Nₘ are connected to sense amplifiers SA₁ , SA₂ , ... , SAₘ₋₁ , SAₘ as differential amplifier stages respectively. The undecided voltage portions are in an undecided (floating) state for a first time, and in a decided state for a second time. For example, for the second time, the potentials at the undecided voltage portions are connected by turning ON the switching transistors (not shown) to a power supply line such as V_{cc} or GND, and thus in this case are decided. Conversely, for the first time, the switching transistors are turned OFF, so that the undecided voltage portions are electrically disconnected from the power supply, i.e., are in a floating state.

For example, for the above-mentioned second time, a small difference in potential is generated between a pair of the undecided voltage portions N₁ and N₁', and thereafter, this difference is amplified by the sense amplifier SA₁. Note that the sense amplifiers SA₁ to SAₘ are operated by a latch enable signal φ_{LE} , and conductor-spacing capacities C₁₁ , C₁₂ , C₂₂ , C₂₃ , ˙˙˙, Cₘ₋₂ , ₘ₋₁, Cₘ₋₁ , ₘ₋₁ , Cₘ₋₁ , ₘ , Cₘ , ₘ exist between the undecided voltage portions.

Also, a line L₁ for an operation clock signal φ is provided on the undecided voltage portions, and therefore conductor-spacing capacities C₁ , C₁', C₂ , C₂', ..., Cₘ₋₁, Cₘ₋₁', Cₘ, Cₘ' exist between the line L₁ and the undecided voltage portions.

Further, decided voltage portions N₀ and Nₘ₊₁ are provided in the outer region of the undecided voltage portions to supply power supply voltages to the sense amplifiers SA₁ , SA₂ , ..., SAₘ₋₁ , SAₘ , and therefore a conductor-spacing capacity C₀₁ exists between the decided voltage portion N₀ and the undecided voltage portion N₁ , and a conductor-spacing capacity Cₘ , ₘ₊₁ also exists between the decided voltages portion Nₘ₊₁ and the undecided voltage portion node Nₘ'.

Where the conductor-spacing capacities are neglected, the operation of the undecided voltage portions such as N₁ and N₁' is shown in Fig. 2A. That is, even when the clock signal φ is changed from a high level to a low level, the potentials at the voltage portions N₁ and N₁' do not change. In practice, however, as shown in Fig.2B, when the clock signal φ is changed from a high level to a low level, the potentials at the voltage portions N₁ and N₁' are both reduced. In this case, noise V₁ received by the outermost undecided voltage portion N₁ is affected by the conductor-spacing capacity C₀₁ of the decided voltage portion N₀ and a noise V₂ received by the undecided voltage portion N₁' adjacent to the undecided voltage portion N₁ is affected by the conductor-spacing capacity between the undecided voltage portion N₁' and the undecided voltage portion N₂. Therefore, the noise V₁ is smaller than the noise V₂ , and as a result, a difference in potential between the undecided voltage portions N₁ and N₁' is generated; therefore, when a normal difference V in potential satisfies V < V₂ - V₁ , or when |V₂ - V₁ - V| is smaller than the sensing ability of the sense amplifier SA₁ , the sense amplifier SA₁ is erroneously operated by the latch enable signal φ_{LE}. This problem also arises in the undecided voltage portions Nₘ and Nₘ', but does not occur at the intermediate undecided voltage portions N₂ , N₂', ..., Nₘ₋₁ , Nₘ₋₁'.

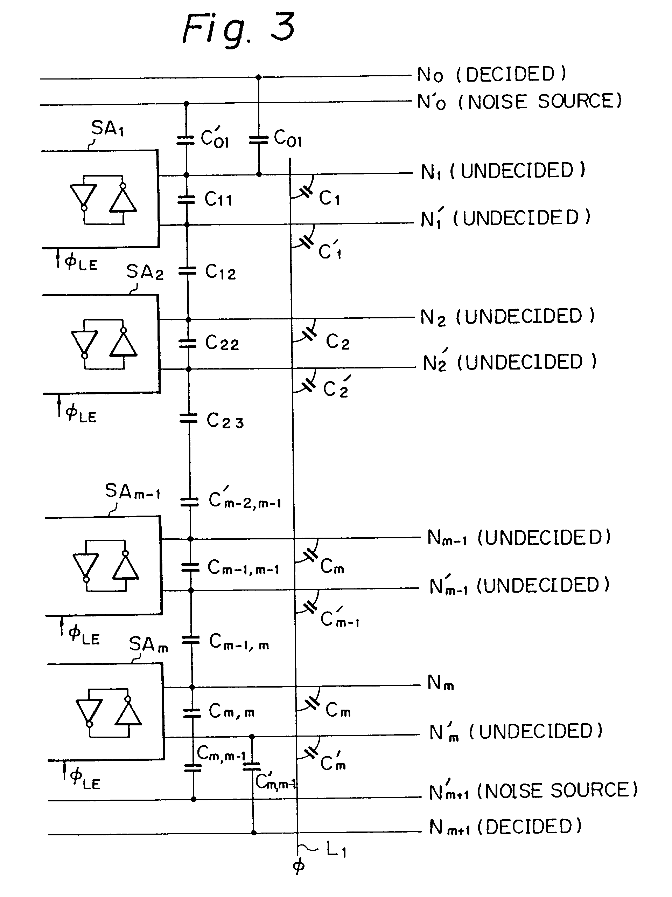

In Fig. 3, noise sources N₀' and Nₘ₊₁' are added to the elements of Fig. 1. The noise source N₀' is provided between the outermost undecided voltage portion N₁ and the decided voltage portion N₀ , and the potential at the noise source N₀' is the same as the potential of the clock signal φ when the undecided voltage portions N₁, N₁', N₂ , N₂', ... , Nₘ₋₁ , Nₘ₋₁', Nₘ , Nₘ' are undecided. Most simply the noise source N₀' is connected to the line L₁. Similarly, the noise source Nₘ₊₁' is provided between the outermost undecided voltage portion Nₘ' and the decided voltage portion Nₘ₊₁ , and the potential at the noise source Nₘ' is the same as the potential of the clock signal φ when the undecided voltage portions N₁ , N₁', N₂ , N₂' ... , Nₘ₋₁ , Nₘ₋₁', Nₘ , Nₘ' are undecided, the noise source Nₘ₊₁' also being connected to the line L₁.

In Fig. 3, the capacity coupling between the outermost voltage portion N₁ (or Nₘ') and the decided voltage portion N₀ (or Nₘ₊₁) becomes weak, but the capacity coupling between the outermost voltage portion N₁ (or Nₘ') and the added noise source N₀' (or Nₘ₊₁') becomes strong. Therefore, each of the pair of outermost undecided voltage portions N₁ and N₁' (or Nₘ and Nₘ') receives an equivalent noise from the clock signal φ, and as a result, the noises V₁ and V₂ of Fig. 2B satisfy V₁ ≅ V₂. Therefore, the sense amplifier SA₁ (or SAₘ) cannot be erroneously operated.

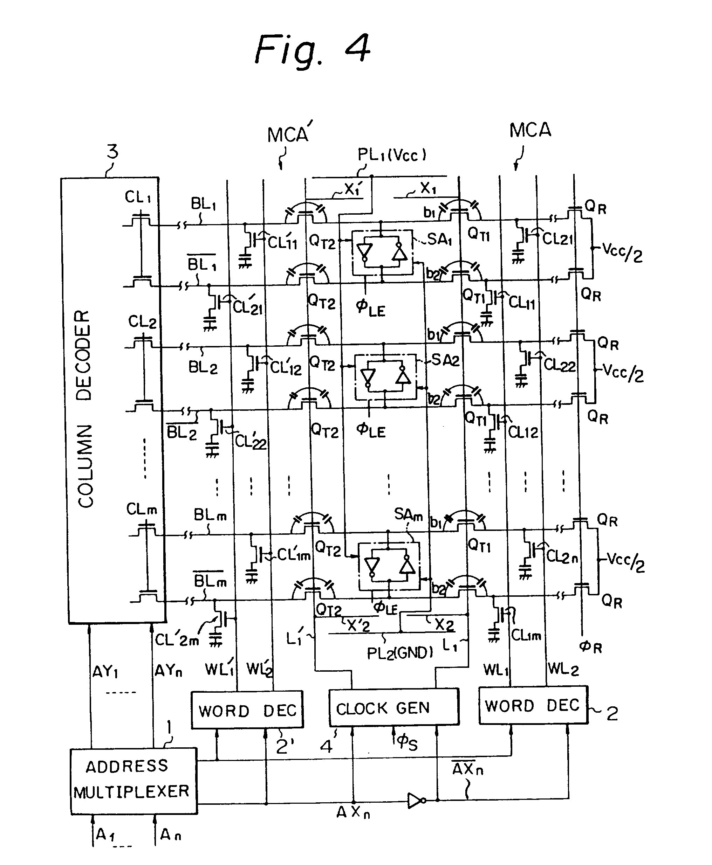

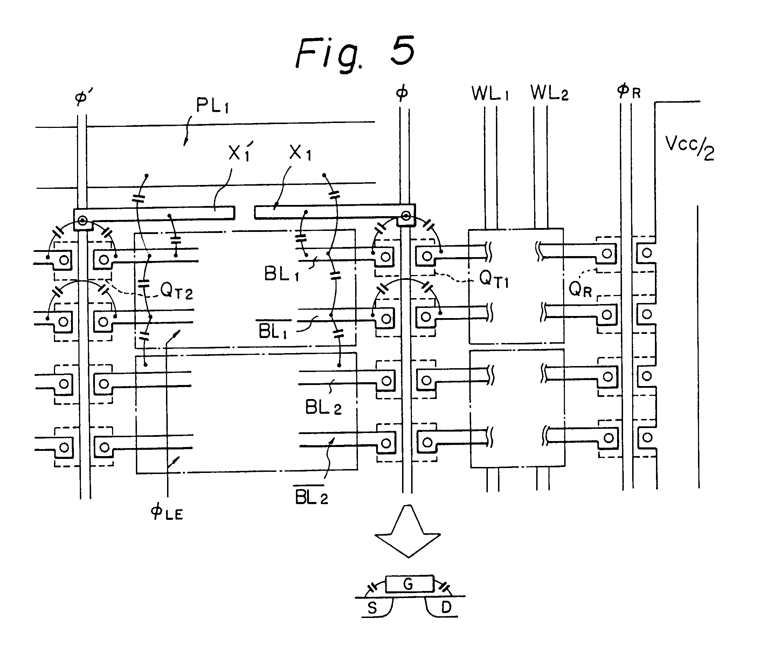

Figure 4 illustrates an embodiment of the semiconductor integrated device according to the present invention, and Fig. 5 is a partial plan view of Fig. 4. In Fig. 4, a MIS memory of the shared-bit-line type having two memory cell array blocks MCA and MCA' is illustrated. In Fig. 4, reference numeral 1 designates an address multiplexer for receiving address signals A₁ through Aₙ from the address buffer (not shown), to generate multiple X-address signals AX₁ through AXₙ and Y-address signals AY₁ through AYₙ. Reference numerals 2 and 2' designate word decoders for selecting one of the word lines WL₁ , WL₂ , ... (WL₁', WL₂', ...) of the memory cell arrays MCA and MCA', respectively, in accordance with the X-address signals AX₁ through AXₙ. Reference numeral 3 designates column decoders for selecting one pair of the bit lines BL₁ , $\overline{\text{BL}}$₁ ; BL₂ , $\overline{\text{BL}}$₂ ; ... BLₘ , $\overline{\text{BL}}$ₘ of the memory cell arrays MCA and MCA' in accordance with the Y address signals AY₁ through AYₙ. Reference 4 designates a clock generator which receives the X address signals AXₙ and $\overline{{\text{AX}}_{\text{n}}}$ and a clock signal φₛ from the RAS clock system (not shown) and generates clock signal φ and φ'.

Also, the bit lines BL₁ , $\overline{\text{BL}}$₁ ; BL₂ , $\overline{\text{BL}}$₂ ; ... , BLₘ , $\overline{\text{BL}}$ₘ are connected, via transfer gates Q_{T1} and Q_{T2} , to sense amplifiers SA₁ , SA₂ , ..., SAₙ , respectively. Further, a power supply source V_{cc}/2 is connected, via precharging gates Q_{R} , to the bit lines BL₁ , $\overline{\text{BL₁}}$ ; BL₂ , $\overline{\text{BL₂}}$ , ... , BLₘ, $\overline{{\text{BL}}_{\text{m}}}$. Further, one-transistor one-capacitor type memory cells CL₁₁ , CL₁₂ , ... , CL₁₁', CL₁₂', ... are connected between the bit lines BL₁ , $\overline{\text{BL₁}}$ , BL₂ , $\overline{\text{BL₂}}$ , ... , BLₘ, $\overline{{\text{BL}}_{\text{m}}}$, and the word lines WL₁ , WL₂ , ... , WL₁', WL_{2'}, ...

Each of the bit lines BL₁ , $\overline{\text{BL₁}}$ , BL₂ , $\overline{\text{BL₂}}$ , ... , BLₘ , $\overline{{\text{BL}}_{\text{m}}}$ serves as an undecided voltage portion.

Also, power supply lines PL₁ and PL₂ are provided for the sense amplifiers SA₁ , SA₂ , ..., and SAₘ. These power supply lines serve as decided voltage portions.

According to the present example, noise sources X₁ and X₁' are provided between the outermost bit line BL₁ (undecided voltage portion) and the power supply line PL₁ (decided voltage portion), and noise sources X₂ and X₂' are provided between the outermost bit line $\overline{{\text{BL}}_{\text{m}}}$ (undecided voltage portion) and the power supply line PL₂ (decided voltage portion).

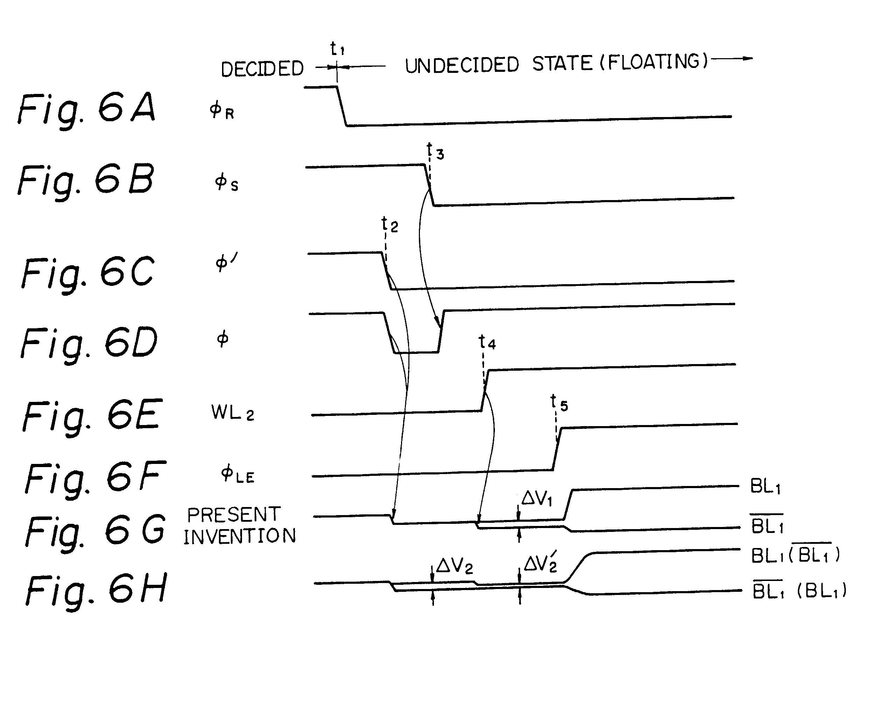

The operation of the circuit of Fig. 4 will be explained with reference to Figs. 6A through 6H. Note that only the bit lines BL₁ and $\overline{\text{BL₁}}$ are illustrated. That is, at an initial stage, all of the bit lines BL₁ and $\overline{\text{BL₁}}$ are reset by a reset signal φ_{R} , as shown in Fig. 6A, to charge the bit lines BL₁ and $\overline{\text{BL₁}}$ at V_{cc}/2 as shown in Fig. 6G. Namely, in this case, although the bit lines BL₁ and $\overline{\text{BL₁}}$ are the undecided voltage portions, the bit lines BL₁ and $\overline{\text{BL₁}}$ are in a decided state. Thereafter, at a time t₁ , when the reset signal φ_{R} becomes low, the bit lines BL₁ and $\overline{\text{BL}}$₁ are separated from the power supply voltage V_{cc}/2, and accordingly, reach an undecided (floating) state. Next, at a time t₂ when the clock signals φ′ and φ are changed from a high level to a low level, the bit lines BL₁ and $\overline{\text{BL₁}}$ are separated from the sense amplifier SA₁ , and in this case, the same noise is generated in the bit line BL₁ and $\overline{\text{BL₁}}$ to reduce the potentials thereof. Next, at a time t₃ , to select the memory cell CL₂₁ , the clock signal φₛ generated from the RAS clock system (not shown) is changed from a high level to a low level and the clock signal φ is changed from a low level to a high level, and thereafter, at a time t₄ , the word line WL₂ is made high by the word decoder 2. As a result, a small difference in potential is generated between the bit lines BL₁ and $\overline{\text{BL₁}}$ , and at a time t₅ this difference is amplified by the sense amplifier SA₁ activated by the high level of the latch enable signal φ_{LE}.

Note that, when different noises are generated by the clock signals φ′ and φ in the bit lines BL₁ and $\overline{\text{BL₁}}$ as in the prior art, this generates a difference ΔV₂ (Fig. 6H) in the potential at this stage. As a result, at a stage when the memory cell C₂₁ is selected, the difference ΔV₂ in potential between the bit lines BL₁ and $\overline{\text{BL}}$₁ may be small or opposite to the content of the memory cell CL₂₁ , and accordingly, the sense amplifier SA₁ may be erroneously operated.

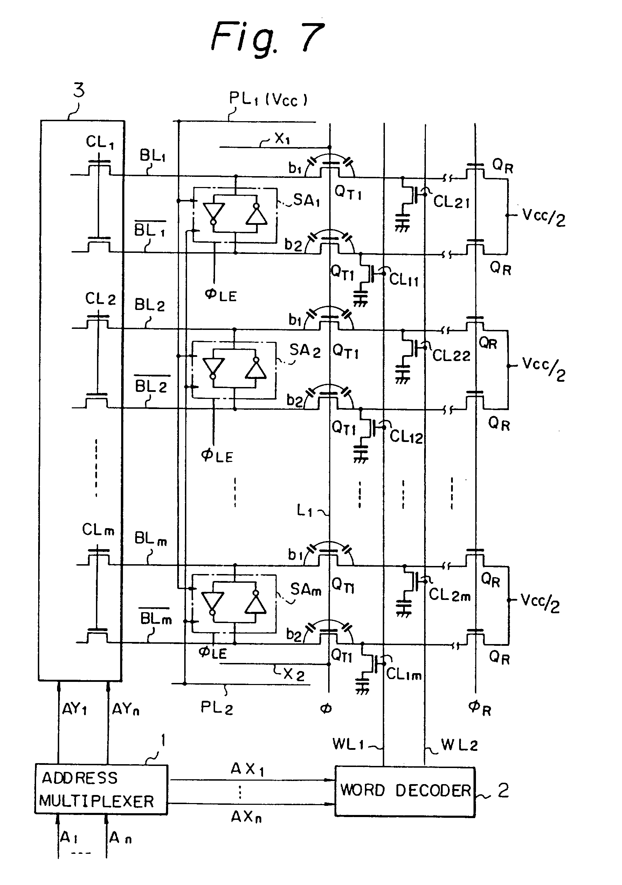

In Fig. 7, which illustrates an embodiment of the semiconductor integrated device according to the present invention, a MIS memory of the folded-bit-line type having a memory cell array block MCA is illustrated. Therefore, in Fig. 7, the word decoder 2′ of Fig. 4 is not provided.

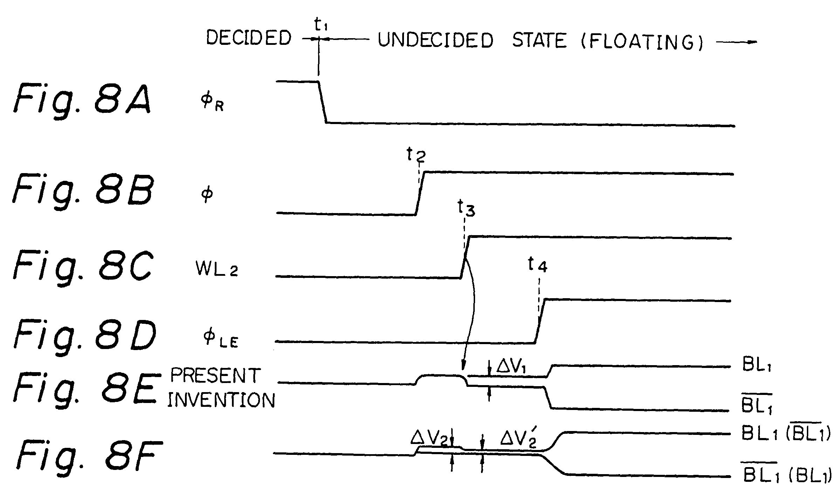

The operation of the circuit of Fig. 7, which is similar to that of Fig. 4, will be explained with reference to Figs. 8A through 8F. Namely, at an initial stage, all of the bit lines BL₁ and $\overline{\text{BL₁}}$ , are reset by the reset signal φ_{R} , as shown in Fig. 8A, to change the bit lines BL₁ and $\overline{\text{BL₁}}$ at V_{cc}/2 as shown in Fig. 8E. Also, in this case, although the bit lines BL₁ and $\overline{\text{BL₁}}$ are the undecided voltage portions, the bit lines BL₁ and $\overline{\text{BL₁}}$ are in a decided state. Thereafter, at a time t₁ when the reset signal φ_{R} becomes low, the bit lines BL₁ and $\overline{\text{BL₁}}$ are separated from the power supply voltage V_{cc}/2, and accordingly, reach an undecided (floating) state. Next, at a time t₂ , to select the memory cell CL₂₁ , the clock signal φ generated from the RAS clock system (not shown) is changed from a low level to a high level, and in this case, the same noise is generated in the bit line BL₁ and $\overline{\text{BL₁}}$ to increase the potentials thereof. Thereafter, at a time t₃ the word line WL₂ is made high by the word decoder 2. As a result, a small difference in potential is generated between the bit lines BL₁ and $\overline{\text{BL₁}}$ , and at a time t₄ , this difference is amplified by the sense amplifier SA₁ activated by the high level of the latch enable signal φ_{LE}.

Note that, in the embodiments of Figs. 4 and 7, the noise sources X₁ (X₁') and X₂ (X₂') are connected to the clock signal line L₁ (L₁′). This actually increases the conductor-spacing capacity between the bit line BL₁ and the clock signal line L₁ (L₁') including the noise source X₁ (X₁') and the conductor-spacing capacity between the bit line $\overline{{\text{BL}}_{\text{m}}}$ and the clock signal line L₁ (L₁′). It is possible to unbalance the conductor-spacing capacity between the bit line BL₁ (BLₘ) and the signal line L₁ (L₁) and the conductor-spacing capacity between the bit line $\overline{\text{BL₁}}$ (BLₘ) and the signal line L₁ (L₁′). In this case, the former capacity is larger than the latter capacity. For example, this can be attained by enlarging the gate area of the transistor Q_{T1} (Q_{T2}) located at the intersection of the bit line BL₁ (BLₘ) and the signal line L₁ (L₁').

As explained above, according to the present invention, an unbalance in potential between the sides of an outer side sense amplifier due to noise can be corrected, to thereby ensure an accurate operation of the sense amplifier, which improves the performance of the semiconductor integrated device. Note, it is possible to provide redundant sense amplifiers and redundant undecided voltage portions as a noise source, but this remarkably increases the area occupied in the device, which is a disadvantage.

In summary, according to the invention, in a semiconductor integrated device having undecided voltage portion pairs, a signal line crossing over or under the undecided voltage portion pairs, and a decided voltage portion, a noise source equivalent to the signal line is provided between the undecided voltage pairs and the decided voltage portion. This noise source, which may be an additional conductor (X₁ , X₁',) branching off from the signal line (L₁), compensates for the difference in capacitance of an undecided voltage portion at the edge of an array from that of internal undecided voltage portions; this ensures that voltages induced in the various portion pairs due to the signal line (L₁) are substantially equal, eliminating unwanted voltage differences between the undecided voltage portions.

## Claims

1. A semiconductor integrated device comprising:
a plurality of pairs of undecided voltage portions (BL₁, $\overline{\text{BL₁}}$ ; BL₂, $\overline{\text{BL}}$₂; ...; BLₘ, $\overline{{\text{BL}}_{\text{m}}}$) which during operation are in an undecided, floating state for a certain time;
a plurality of sensing means (SA₁ , SA₂ ... , SAₘ₋₁ , SAₘ) each connected to one of the pairs of undecided voltage portions, for sensing a small difference in potential between the portions;
a decided voltage portion (PL₁ , PL₂) arranged on an outer side of the undecided voltage portion pairs; and
a signal line (L₁) crossing the pairs of undecided voltage portions;
a capacitance-increasing means (X₁, X₂, X₁', X₂') arranged in the vicinity of the outermost undecided voltage portions;
characterised in that this capacitance-increasing means comprises a conductor (X₁ , X₁', ...) branching from the signal line (L₁) and extending in parallel to the said outermost undecided voltage portions (BL₁, $\overline{{\text{BL}}_{\text{m}}}$).

2. A device as set forth in claim 1 and being a MIS memory device of the shared-bit-line type or folded-bit-line type, the undecided voltage portion pairs comprising bit line pairs (BL₁ , BL₁; BL₂ , BL₂ ; ..., BLₘ , BLₘ) and the said decided voltage portion comprising a power supply line (PL₁ , PL₂) for supplying a power-supply voltage to the sensing means.

3. A device as set forth in claim 1 or 2, in which the capacitance between the outermost undecided voltage portion (BL₁ , $\overline{{\text{BL}}_{\text{m}}}$) and the signal line (L₁) is larger than that between the inwardly adjacent undecided voltage portion ($\overline{\text{BL₁}}$ , BLₘ) and the signal line.

4. A dynamic semiconductor memory device as set forth in any preceding claim, in which the undecided voltage portion pairs are bit line pairs (BL₁, $\overline{\text{BL₁}}$, ...) arranged in parallel, the sensing means are sense amplifiers (SA₁ , SA₂ ,...) each connected to one bit line pair, a plurality of dynamic memory cells (CL₁₁ , CL₁₂ , ...) are connected to the bit line pairs; and a precharge circuit (Q_{R}) is connected to the bit line pairs, for precharging each bit line pair.

5. A device as set forth in claim 4, further comprising a plurality of transfer gate transistors (Q_{T1} , Q_{T2}) each connected between one of the sense amplifiers and one bit line of the bit line pairs, the transfer gate transistors being controlled by a signal generated on the said signal line.

6. A device as set forth in claim 5, wherein the capacitance-increasing means involves an enlargement of the gate area of those transfer gate transistors (Q_{T1}, Q_{T2}) corresponding to the said outermost bit lines.

7. A semiconductor integrated device according to any preceding claim, wherein the capacitance-increasing means is arranged between the said decided voltage portion and the outer undecided voltage portions.

## Patentansprüche

1. Integrierte Halbleitervorrichtung, enthaltend:
eine Mehrzahl von Paaren von unbestimmten Spannungsportionen (BL₁, $\overline{\text{BL₁}}$; BL₂, $\overline{\text{BL₂}}$; ...; BLₘ, $\overline{{\text{BL}}_{\text{m}}}$), die während des Betriebs für eine bestimmte Zeit in einem unbestimmten, schwebenden Zustand sind,
eine Mehrzahl von Leseeinrichtungen (SA₁, SA₂, ..., SAₘ₋₁, SAₘ), von denen jede mit einem der Paare von unbestimmten Spannungsportionen verbunden ist, um eine kleine Potentialdifferenz zwischen den Portionen abzutasten,
eine bestimmte Spannungsportion (PL₁, PL₂), die an einer Außenseite der unbestimmten Spannungsportionspaare angeordnet ist, und
eine Signalleitung (L₁), die die Paare von unbestimmten Spannungsportionen kreuzt,
Kapazitätserhöhungseinrichtungen (X₁, X₂, X₁', X₂'), die in der Nähe der äußersten unbestimmten Spannungsportionen angeordnet sind,
dadurch gekennzeichnet, daß diese Kapazitätserhöhungseinrichtungen einen Leiter (X₁, X₁', ...) enthalten, der von der Signalleitung (L₁) abzweigt und parallel zu den äußersten unbestimmten Spannungsportionen (BL₁, $\overline{{\text{BL}}_{\text{m}}}$) verläuft.

2. Vorrichtung nach Anspruch 1 in Form einer MIS-Speichervorrichtung der geteilten Bitleitungsart oder der gefalteten Bitleitungsart, wobei die unbestimmten Spannungsportionspaare Bitleitungspaare (BL₁, $\overline{\text{BL₁}}$; BL₂, $\overline{\text{BL₂}}$ ;..., BLₘ, $\overline{{\text{BL}}_{\text{m}}}$) enthalten und die bestimmte Spannungsportion eine Energieversorgungsleitung (PL₁, PL₂) enthält, um den Leseeinrichtungen eine Energieversorgungsspannung zuzuführen.

3. Vorrichtung nach Anspruch 1 oder 2, bei der die Kapazität zwischen der äußersten unbestimmten Spannungsportion (BL₁, $\overline{{\text{BL}}_{\text{m}}}$) und der Signalleitung (L₁) größer als jene zwischen der einwärtsliegend angrenzenden unbestimmten Spannungsportion ($\overline{\text{BL₁}}$, BLₘ) und der Signalleitung ist.

4. Dynamische Halbleiterspeichervorrichtung nach einem der vorhergehenden Ansprüche, in der die Spannungsportionspaare parallel angeordnete Bitleitungspaare (BL₁, $\overline{\text{BL₁}}$, ...) sind, die Leseeinrichtungen Leseverstärker (SA₁, SA₂, ...) sind, von denen jeder mit einem Bitleitungspaar verbunden ist, eine Mehrzahl von dynamischen Speicherzellen (CL₁₁, CL₁₂, ...) mit den Bitleitungspaaren verbunden sind und eine Vorladungsschaltung (Q_{R}) mit den Bitleitungspaaren zum Vorladen jedes Bitleitungspaars verbunden ist.

5. Vorrichtung nach Anspruch 4, ferner enthaltend eine Mehrzahl von Transfergate-Transistoren (Q_{T1}, Q_{T2}), von denen jeder zwischen einem der Leseverstärker und einer Bitleitung der Bitleitungspaare angeschlossen ist, wobei die Transfergate-Transistoren durch ein auf der Signalleitung erzeugtes Signal gesteuert werden.

6. Vorrichtung nach Anspruch 5, wobei die Kapazitätserhöhungseinrichtungen eine Vergrößerung des Gatebereichs jener Transfergate-Transistoren (Q_{T1}, Q_{T2}) bedeuten, die den äußersten Bitleitungen entsprechen.

7. Integrierte Halbleitervorrichtung nach einem der vorhergehenden Ansprüche, wobei die Kapazitätserhöhungseinrichtungen zwischen der bestimmten Spannungsportion und den äußeren unbestimmten Spannungsportionen angeordnet sind.

## Revendications

1. Dispositif intégré à semiconducteur comprenant :
une pluralité de paires de parties à tension indéterminée (BL₁, $\overline{\text{BL₁}}$ ; BL₂, $\overline{\text{BL₂}}$ ; .... BLₘ, $\overline{\text{BL}}$ₘ) qui, durant le fonctionnement, sont dans un état indéterminé, flottant, pendant un certain temps ;
une pluralité de moyens de détection (SA₁, SA₂, .... SAₘ₋₁, SAₘ), qui sont chacun connectés à l'une des paires de parties à tension indéterminée, afin de mesurer une petite différence de potentiel entre les parties ;
une partie à tension déterminée (PL₁, PL₂) disposée sur un côté extérieur des paires de parties à tension indéterminée ;
une ligne de signal (L₁) croisant les paires de parties à tension indéterminée ; et
un moyen d'augmentation de capacité (X₁, X₂, X₁', X₂') disposé au voisinage des parties à tension indéterminée situées le plus à l'extérieur ;
caractérisé en ce que ce moyen d'augmentation de capacité comprend un conducteur (X₁, X₁', ....) se ramifiant à partir de la ligne de signal (L₁) et se prolongeant en parallèle jusqu'aux dites parties à tension indéterminée situées le plus à l'extérieur (BL₁, $\overline{\text{BL}}$ₘ).

2. Dispositif selon la revendication 1, qui est un dispositif de mémoire MIS du type à lignes de bit partagées ou du type à lignes de bit repliées, les paires de parties à tension indéterminée comprenant des paires de lignes de bit (BL₁, $\overline{\text{BL}}$₁ ; BL₂, $\overline{\text{BL}}$₂ ; .... BLₘ, $\overline{\text{BL}}$ₘ), et ladite partie à tension déterminée comprenant une ligne d'alimentation électrique (PL₁, PL₂) qui sert à alimenter en tension électrique les moyens de détection.

3. Dispositif selon la revendication 1 ou 2, dans lequel la capacité entre la partie à tension indéterminée située le plus à l'extérieur (BL₁, $\overline{\text{BL}}$ₘ) et la ligne de signal (L₁) est plus grande qu'entre la ligne à tension indéterminée adjacente du côté intérieur ($\overline{\text{BL}}$1, BLₘ) et la ligne de signal.

4. Dispositif de mémoire à semiconducteur dynamique selon l'une quelconque des revendications précédentes, dans lequel les paires de parties à tension indéterminée sont des paires de lignes de bit (BL₁, $\overline{\text{BL}}$₁ ; ....) disposées parallèlement, les moyens de détection sontdes amplificateurs de lecture (SA₁, SA₂, ...) connectés chacun à une paire de lignes de bits, une pluralité de cellules de mémoire dynamique (CL₁₁, CL₁₂, ....) sont connectées aux paires de lignes de bit, et un circuit de précharge (Q_{R}) est connecté aux paires de lignes de bit afin de précharger chaque paire de lignes de bit.

5. Dispositif selon la revendication 4, comprenant en outre une pluralité de transistors faisant fonction de portes de transfert (Q_{T1}, Q_{T2}) connectés chacun entre l'un des amplificateurs de lecture et une ligne de bit des paires de lignes de bit, les transistors portes de transfert étant commandés par un signal produit sur ladite ligne de signal.

6. Dispositif selon la revendication 5, où le moyen d'augmentation de capacité fait intervenir un agrandissement de l'aire de grille de ceux des transistors portes de transfert (Q_{T1}, Q_{T2}) qui correspondent auxdites lignes de bit situées le plus à l'extérieur.

7. Dispositif intégré à semiconducteur selon l'une quelconque des revendications précédentes, où le moyen d'augmentation de capacité est disposé entre ladite partie à tension déterminée et les parties à tension indéterminée extérieures.
